# EUROPEAN PATENT APPLICATION

(11) **EP 0 779 646 A1**
(43) Date of publication of application: **18.06.1997**
(21) Application number: 95830518.7
(22) Date of filing: 14.12.1995
(51) Int. Cl.: H01L 21/00, H01L 27/115, H01L 21/8247

(54) **Method of fabricating EEPROM memory devices, and EEPROM memory devices so formed**

(71) Applicant: SGS-THOMSON MICROELECTRONICS s.r.l., 20041 Agrate Brianza (Milano) (IT)
(72) Inventor: Vajana, Bruno, I-24100 Bergamo (IT); Baldi, Livio, I-20041 Agrate Brianza (IT)
(74) Representative: Cerbaro, Elena

(57) **Abstract**

A method of fabricating an EEPROM memory cell, including the steps of depositing a thick gate oxide layer on a substrate of P-type semiconductor material; forming on the substrate a tunnel mask of photoresist material presenting a window; implanting N-type ions in the substrate through the window of the tunnel mask to form a continuity region; removing the exposed portion of the gate oxide layer; growing a thin tunnel oxide region on the substrate, at the window of the tunnel mask; depositing a first and second polysilicon layer separated by a dielectric layer; patterning floating gate, control gate and gate oxide regions in self-aligned manner; and forming N-type source and drain regions offset laterally in relation to the gate regions. The implanted continuity region is thus self-aligned with the tunnel region, and lateral diffusion of the dope provides for electric continuity with the drain region.

## Description

The present invention relates to a method of fabricating EEPROM memory devices, and to an EEPROM memory device so formed.

As is known, a market demand exists for increasingly larger EEPROM memories (> 256 Kb), which means a corresponding reduction in cell size.

In the case of EEPROM memories with a double polysilicon level and a floating gate (so-called FLOTOX memories), which are now the most commonly used by major world producers, the mask aligning process has been found to be the main size reducing obstacle.

EEPROM memories - which are programmed by the passage of electric charges to a floating gate region by tunneling through a thin oxide region (Fowler-Nordheim current) - comprise a thin oxide region (tunnel oxide) surrounded by a thicker oxide region (gate oxide) arranged between the floating gate region and the substrate. The thin oxide region permits passage of the Fowler-Nordheim current to program the cell, while the thicker gate oxide layer provides for increasing the coupling coefficient of the floating gate and overlying control gate (which also depends on parasitic capacitances such as that between the floating gate and substrate, and hence on the thickness of the gate oxide), and for reducing any undesired parasitic phenomena such as band-to-band tunneling (i.e. the presence of parasitic currents due to charges passing directly from the valence band to the silicon conducting band).

EEPROM memories also require an implanted region (normally implanted with phosphorous for N-channel cells) beneath and to the side of the tunnel oxide region and partially superposed to the drain region of the cell to ensure electric continuity between the substrate region beneath the tunnel oxide (tunnel area) and the drain region of the cell. The implanted region must also extend a fair way over the tunnel area to permit generation of the tunnel current, but must not extend too far beneath the gate oxide towards the source region to prevent excessively reducing the actual length of the channel region (sensing transistor of the cell).

As such, the tunnel oxide and implanted regions are formed using two masks respectively defining the tunnel oxide area and the heavy (capacitor) implant area.

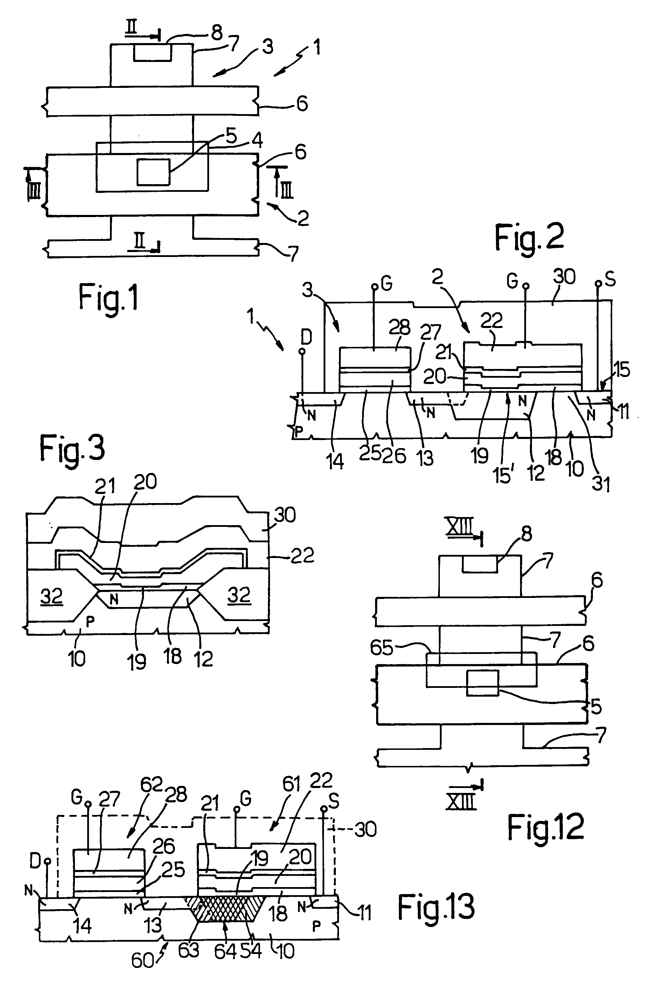

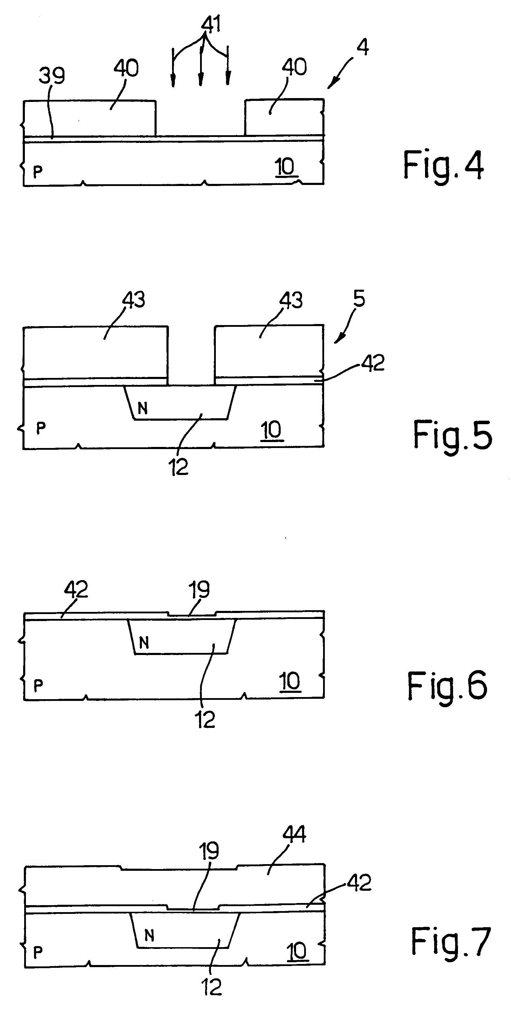

It is these two masks, and more specifically the need for aligning them, that prevents a reduction in cell size, as explained below with reference to Figures 1-3 showing a known EEPROM cell, and Figures 4-7 showing the known method of fabricating it.

Figures 2 and 3 show a portion of a known memory device 1 comprising a cell 2 and a selection transistor 3. Number 10 in Figures 2 and 3 indicates the P-type substrate of device 1, which is formed, using the twin tub method or not, inside a semiconductor wafer of monocrystalline material, and houses an N-type source region 11 of cell 2, an N-type implanted electric continuity region 12, an N-type drain/source region 13 defining the drain region of cell 2 and the source region of selection transistor 3, and an N-type drain region 14 for selection transistor 3. All of regions 11-14 face the surface 15 of substrate 10.

Stacked on surface 15 are: a gate oxide region 18 of cell 2, surrounding a thin tunnel oxide region 19; a first portion 20 of a first polycrystalline silicon layer (poly1) forming the floating gate of cell 2; a first portion 21 of an interpoly dielectric layer; and a first portion 22 of a second polycrystalline silicon layer (poly2) forming the control gate region of cell 2. Also stacked on surface 15 are: a gate oxide region 25 of selection transistor 3; a second portion 26 of poly1; a second portion 27 of the interpoly dielectric layer; and a second portion 28 of poly2. An intermediate dielectric layer 30 covers the structure and insulates the various layers.

As shown in the Figure 3 section, the floating gate region (portion 20 of poly1) is insulated and surrounded at the top and sides by interpoly dielectric layer 21 (preferably an ONO layer formed of superimposed silicon Oxide-silicon Nitride-silicon Oxide) and at the bottom by gate oxide 19 and tunnel oxide 18 of cell 2; whereas (not shown) portions 26 and 28 of poly1 and poly2 of selection transistor 3 are shorted at the memory circuitry (not shown), upstream and downstream from the Figure 2 section.

Portion 15' of surface 15 beneath tunnel oxide region 19 forms the tunnel area; the distance between floating gate region 20 and surface 15 is minimum (about 80 Å) at portion 15', and is greater (about 200 Å) at gate oxide 18; and the substrate portion 31 between continuity region 12 and source region 11 forms the channel of cell 2.

As shown in Figure 3, electric continuity region 12 and channel region 31 (not shown in the Figure 3 section) are defined laterally, widthwise, by a thick field oxide layer 32.

Device 1 is formed using the masks in Figure 1, which shows a capacitor implant mask 4; a tunnel mask 5; a self-aligned etching mask 6 (explained below); a source/drain implant mask 7 for cell 2 and selection transistor 3; and a mask 8 for forming drain contact D.

Device 1 is fabricated using a typical CMOS (twin or single tub) method whereby, starting from P-type substrate 10, field oxide layer 32 (Figure 3) defining the active areas of device 1 is grown; a sacrifical oxide layer 39 is grown; capacitor implant mask 4 is formed comprising a layer 40 of photoresist material covering the whole of sacrifical oxide layer 39 except for a window as shown in Figure 4; the implant, shown schematically in Figure 4 by arrows 41, is made through sacrifical layer 39 to form continuity region 12; mask 40 and layer 39 are removed; a gate oxide layer 42 (Figure 5) is deposited (to form gate region 18 of cell 2 and the gate oxide layer of selection transistor 3); tunnel mask 5 is deposited comprising a layer 43 of photoresist material covering the whole of gate oxide layer 42 except for a window (Figure 5) where tunnel region 19 is to be formed; and dedicated etching is performed to clean surface 15, remove the exposed portion of layer 42, and obtain the intermediate structure shown in Figure 5.

Tunnel mask 5 is then removed, and tunnel oxide region 19 surrounded by gate oxide layer 42 is grown to obtain the intermediate structure shown in Figure 6.

At this point, first polycrystalline silicon layer (poly1) 44 is deposited and doped (Figure 7); polyl layer 44 is patterned to define, widthwise (horizontal direction in Figures 1 and 3), the floating gate regions 20 of the cells; the composite ONO layer is deposited; ONO layer 21 is etched at the circuit portion of device 1; the second polycrystalline silicon layer (poly2) is deposited and doped; poly2, the ONO layer, polyl and gate oxide layer 42 are self-align etched using mask 6, to define, lengthwise (vertical direction in Figure 1), floating and control gate regions 20 and 22; a protective oxide layer (incorporated in dielectric layer 30 and therefore not shown) is grown over control gate regions 22; a first light drain/source implant is possibly effected; spacers (not shown) are formed to the side of the control and floating gate regions; a source/drain implant is effected using mask 7 to form regions 11, 13, 14 (and the structure shown in Figures 2 and 3); and the usual finish steps are performed, including forming intermediate dielectric layer 30 and the contacts, and depositing the passivation layer.

Capacitor implant and tunnel masks 4 and 5 are the cause of the aligning problems referred to previously, and prevent a reduction in cell size in the horizontal direction in Figure 2 (vertical direction in Figure 1).

With known cells, in fact, to enable programming of the cell and reduce undesired parasitic phenomena as mentioned previously, device 1 is so designed that continuity region 12 extends beneath the whole of tunnel oxide region 19, i.e. masks 4 and 5 are so sized that, viewed from above (Figure 1), the window defined by tunnel mask 5 is inside the window defined by capacitor implant mask 4, even in the presence of fabrication tolerances and minor misalignments of the masks, which are usual with current manufacturing processes. To ensure the masks are superimposed, minimum theoretical sizing is impossible, thus resulting in a considerable loss in area, which is in direct contrast with the demand for smaller cells.

It is an object of the present invention to provide a fabrication method enabling a reduction in cell area.

According to the present invention, there are provided a method of fabricating EEPROM memory devices, and an EEPROM memory device so formed, as claimed respectively in Claims 1 and 14.

A number of preferred, non-limiting embodiments of the present invention will be described by way of example with reference to the accompanying drawings, in which:
Figure 1 shows a plan view of a number of masks used to fabricate a known EEPROM memory device;
Figure 2 shows a cross section of the known memory device along line II-II in Figure 1;
Figure 3 shows a cross section of the known memory device along line III-III in Figure 1;
Figures 4-7 show cross sections of the memory cell of the known device, as in Figure 2, at different steps in the fabrication of the cell;
Figure 8 shows a plan view of a number of masks used to fabricate a first embodiment of an EEPROM memory device in accordance with the present invention;
Figure 9 shows a cross section along line IX-IX in Figure 8 of the device formed according to the invention using the Figure 8 masks;
Figure 10 shows a cross section of the Figure 9 memory device along line X-X in Figure 8;
Figure 11 shows a cross section, similar to Figure 9, of an intermediate fabrication step;
Figure 12 shows a plan view of a number of masks used to fabricate a second embodiment of an EEPROM memory device in accordance with the present invention;
Figure 13 shows a cross section of the Figure 12 memory device along line XIII-XIII in Figure 12;
Figure 14 shows a plan view of a number of masks used to fabricate a third embodiment of an EEPROM memory device in accordance with the present invention;
Figure 15 shows a cross section of the Figure 14 memory device along line XV-XV in Figure 14;
Figure 16 shows a cross section, similar to Figure 15, of an intermediate fabrication step.

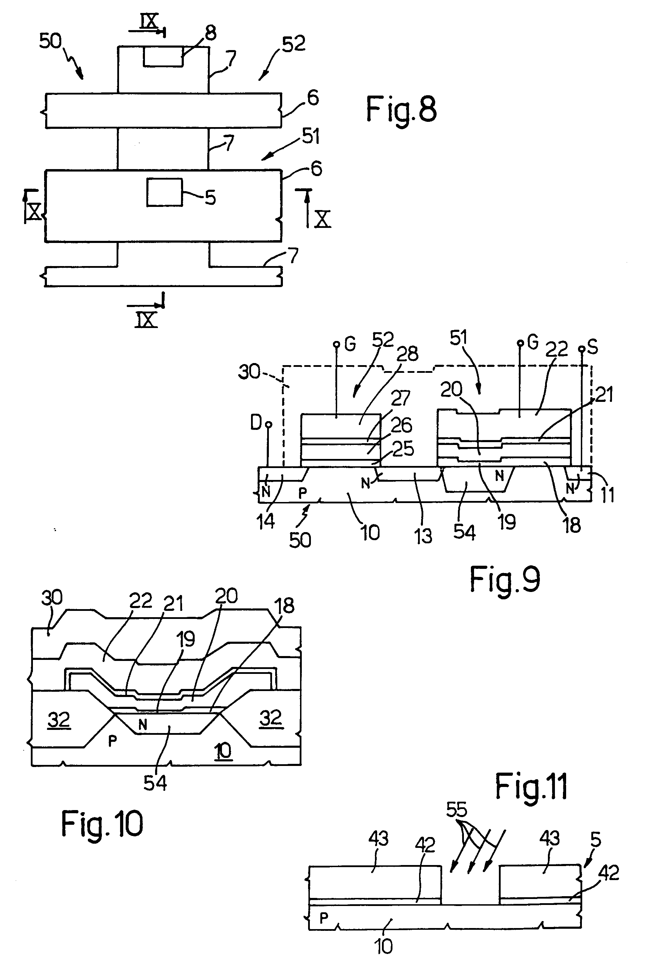

Figures 8-10, similar to Figures 1-3, relate to a first embodiment 50 of an EEPROM memory device in accordance with the present invention, and show a portion comprising a cell 51 and a selection transistor 52 similar to the known cell 2 and selection transistor 3 except for the arrangement of the continuity region, which in Figures 8-10 is therefore indicated 54. Any other parts of the device and any masks common to the known memory device 1 are indicated using the same numbering system as previously.

More specifically, continuity region 54 of device 50, instead of being formed using a special mask and of overlapping drain region 13 of the cell and the portion of substrate 10 beneath gate and tunnel oxide regions 18, 19, is formed using the tunnel mask, directly beneath tunnel oxide region 19, so that it is centered and self-aligned in relation to region 19, and continuity with drain region 13 is achieved using the lateral diffusion of the capacitor implant. This therefore provides for eliminating, in the direction of vertical section IX-IX in Figure 8, the dimensional restrictions imposed in the known device by the need to superimpose two different masks, even in the presence of fabrication tolerances and misalignment, and permits a reduction in the size of cell 51 of as much as 0.1-0.2 µm.

Cell 51 and selection transistor 52 are fabricated using a method comprising the same initial steps as in the known method up to the capacitor implant mask. More specifically, commencing from P-type substrate 10, field oxide layer 32 (Figure 10) is grown, and the gate oxide layers of cell 51 and selection transistor 52 are deposited. Unlike the known method, the capacitor implant mask is dispensed with, and tunnel mask 5 comprising a layer of photoresist material 43 is deposited directly to cover the whole of gate oxide layer 42 except for a window as shown in Figure 11. Using mask 5, dedicated etching is performed to clean surface 15 and so remove the exposed portion of layer 42; the capacitors are implanted, possibly with a given tilt (arrows 55 in Figure 11) towards drain region 13 of the cell to assist electric continuity; tunnel mask 5 is removed; tunnel oxide region 19 is grown; and the method then continues with the same steps as in the known method, including: depositing, doping and patterning first polycrystalline silicon layer (poly1) 44; depositing and patterning the composite ONO layer; depositing and doping the second polycrystalline silicon layer (poly2); self-aligned etching poly2, the ONO layer, poly1 and gate oxide layer 42 using mask 6; forming the spacers; source/drain implanting using mask 7 in Figure 8; and the usual finish steps including forming intermediate dielectric layer 30, forming the contacts, and depositing the passivation layer.

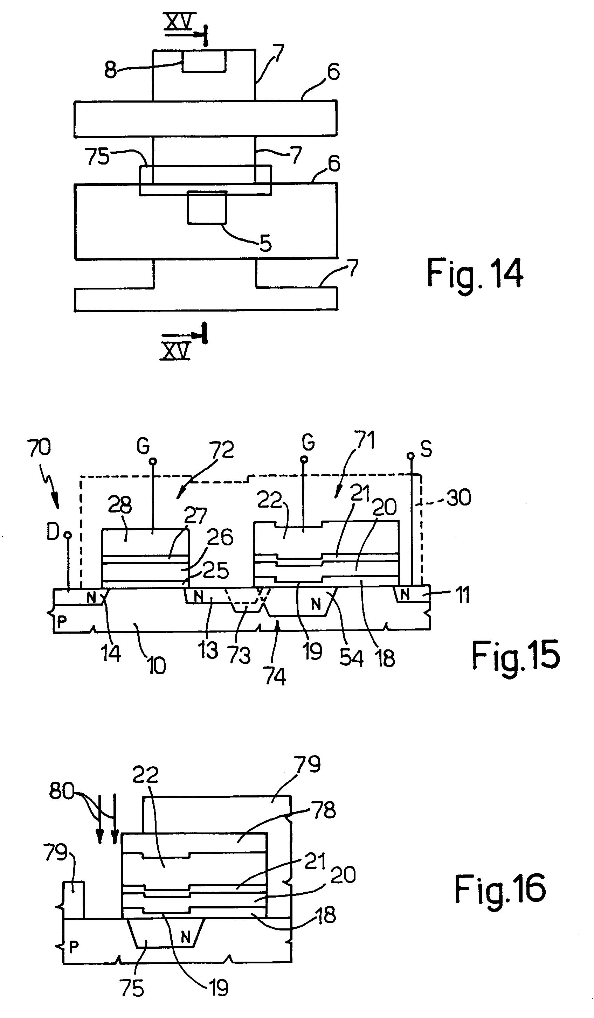

Figures 12 and 13 respectively show the mask layout and a cross section of a second embodiment 60 of the memory device comprising a memory cell 61 and a selection transistor 62. In this embodiment, in addition to continuity region 54 self-aligned with tunnel oxide region 19, an auxiliary region 63 is also formed overlapping tunnel region 19 and drain region 13. Auxiliary region 63 and region 54 form an overall region 64. Two implants are therefore made to form overall region 64: a first implant using a special mask 65 and prior to forming the tunnel oxide region; and a second implant using tunnel mask 5 and as described with reference to Figures 8-11.

More specifically, in the Figure 12-13 embodiment, after the initial fabrication steps, which are the same as in the known method up to the formation of the sacrifical oxide layer (not shown), an auxiliary heavy implant mask 65 is formed. This is an N-type implant, preferably of phosphorous, similar to the capacitor implant of known devices using mask 4, but, instead of forming the whole continuity region as in the known method, it provides solely for forming an auxiliary region having one end definitely overlapping drain region 13, regardless of the effects of lateral diffusion (which vary according to the process used). In the Figure 12 layout, therefore, the window of mask 65 only partially overlaps and do not completely cover the window of tunnel mask 5, so that the tunnel oxide and continuity regions need no longer be superimposed on the side facing the source region of the cell (the right side in the Figure 2 and 13 cross sections), even in the presence of fabrication tolerances and misalignment, and the auxiliary implant mask 65 and tunnel mask 5 need not be oversized.

The above implant therefore forms N-type auxiliary region 63, one portion of which definitely overlaps drain region 13, but which, as stated, does not cover the whole of tunnel area 15', as indicated by the positive-slope hatching in Figure 13. At this point, mask 65 is removed; gate oxide layer 42 is deposited; tunnel mask 5 is formed in known manner; prior to cleaning and removal of the exposed portion of gate oxide layer 42, a heavy implant of phosphorous is made to form N-type continuity region 54 (shown by the negative-slope hatching in Figure 13) overlapping auxiliary region 63 and self-aligned with the tunnel oxide region; the exposed portion of layer 42 is removed; tunnel mask 5 is removed; tunnel oxide region 19 is grown; and the other regions of the device are formed in known manner not described.

Figures 14-16 show the mask layout and a third embodiment 70 of the memory device comprising a memory cell 71 and a selection transistor 72. As in the second embodiment, in addition to continuity region 54 self-aligned with tunnel oxide region 19, an auxiliary region 73 is formed extending along the edge of the stack of self-aligned regions 18, 20, 21, 22 contiguous to drain region 13. Regions 54, 73 together form an overall region 74, which is formed by two implants: a first implant carried out using a special mask 75 after forming stacked regions 18, 20, 21, 22; and a second implant carried out using tunnel mask 5 as described with reference to Figures 8-11.

More specifically, the initial steps in the fabrication method of the Figure 14-16 embodiment are the same as for the first embodiment, and comprise: growing field oxide layer 32; depositing the gate oxide layers of cell 71 and selection transistor 72; forming tunnel mask 5; first capacitor implanting using mask 5 to form continuity region 54; removing mask 5; growing tunnel oxide region 19; depositing, doping and patterning first polycrystalline silicon layer (poly1) 44; depositing and patterning the composite ONO layer; depositing and doping the second polycrystalline silicon layer (poly2); self-aligned etching poly2, the ONO layer, poly1 and gate oxide layer 42; and forming a protective oxide layer (78 in Figure 16).

At this point, before forming the spacers, mask 75 is formed comprising a resist layer 79 covering the entire surface except for a window overlapping the portion of the substrate where drain region 13 is to be formed, and the stack of regions 18, 20, 21, 22, 78; and an implant of appropriate strength and energy (shown by arrows 80 in Figure 16, and preferably of phosphorous) is made to form auxiliary region 73 in Figure 15. More specifically, the phosphorous so diffuses laterally that auxiliary region 73 penetrates slightly beneath gate oxide region 18 and towards tunnel oxide region 19 to enrich the total concentration of N-type doping species (in particular, phosphorous) and so ensure electric continuity.

This is then followed by the usual steps comprising the source/drain implant (mask 7), and the finish steps.

In the third embodiment also, therefore, masks 75 and 5 need not be aligned (particularly as regards the side of mask 75 facing tunnel region 19), so that overall region 74 may be formed without oversizing masks 75 and 5, and the overall size of the cell may be reduced.

The method described presents the following advantages. In particular, the fabrication method relative to the first embodiment provides for reducing the number of masks required, thus affording advantages not only in terms of mask alignment tolerances and cell size scalability, but also in terms of the defectiveness and manufacturability of the device. The first embodiment is therefore preferable when process conditions ensure sufficient lateral diffusion of the capacitor implant and, hence, electric continuity with the drain region. Conversely, i.e. when continuity is not guaranteed by the process, the second or third fabrication method may be applied, which nevertheless provide for achieving the same size scalability advantages.

Clearly, changes may be made to the fabrication method and device as described and illustrated herein without, however, departing from the scope of the present invention. In particular, in all the embodiments described, the tilt angle of the doping species implant to form the continuity region may vary, and the implant itself may be made in conventional manner or tilted to better distribute the doping atoms to the drain region and so enhance electric continuity between the drain region and capacitor implant.

## Claims

1. A method of fabricating EEPROM memory devices, comprising the steps of:
- forming a tunnel insulating region surrounded by a gate insulating region; said tunnel and gate insulating regions extending over a substrate of semiconductor material of a first conductivity type; and said tunnel insulating region being thinner than said gate insulating region;
- forming a conducting region of a second conductivity type in said substrate; said conducting region being offset laterally in relation to said tunnel insulating region; and
- forming a continuity region of said second conductivity type in said substrate, beneath said tunnel insulating region, and in electric continuity with said conducting region;
characterized in that said tunnel insulating region and said continuity region are formed using a single mask of photoresist material.

2. A method as claimed in Claim 1, characterized in that it comprises the step of depositing a gate insulating layer on said substrate;
in that said step of forming a continuity region comprises the steps of:
- depositing on said gate insulating layer a mask of photoresist material presenting a window; and
- implanting doping species through said window to determine said second conductivity type;
and in that said step of forming a tunnel insulating region comprises the step of:
- removing an exposed portion of said gate insulating layer at said window; and
- growing said tunnel insulating region on said substrate, where said exposed portion of said gate insulating layer has been removed.

3. A method as claimed in Claim 2, characterized in that said step of removing an exposed portion is performed prior to said step of implanting doping species.

4. A method as claimed in Claim 2, characterized in that said step of removing an exposed portion is performed after said step of implanting doping species and prior to said step of growing said tunnel insulating region.

5. A method as claimed in Claim 2, characterized in that said step of implanting doping species comprises the step of tilt implanting.

6. A method as claimed in any one of the foregoing Claims, characterized in that it also comprises the step of forming an auxiliary region overlapping said conducting region and said continuity region.

7. A method as claimed in Claim 6, characterized in that said step of forming an auxiliary region comprises the step of implanting further doping species determining said second conductivity type, prior to said steps of forming said continuity and tunnel insulating regions.

8. A method as claimed in Claim 7, characterized in that said step of forming an auxiliary region comprises the step of forming on said substrate an auxiliary mask presenting a window arranged astride and partially overlapping a portion of said substrate for housing said conducting region, and a portion of said substrate to be overlapped by said tunnel insulating region.

9. A method as claimed in Claim 6, characterized in that said step of forming an auxiliary region comprises the step of implanting further doping species determining said second conductivity type, after said steps of forming said continuity and tunnel insulating regions.

10. A method as claimed in Claim 9, characterized in that it comprises the steps of forming a self-aligned stack of floating gate, electric insulation and control gate regions; and in that said step of forming an auxiliary region is performed after said step of forming said self-aligned stack.

11. A method as claimed in Claim 10, characterized in that said step of forming an auxiliary region comprises the step of forming an auxiliary mask presenting a window overlapping the substrate portion for housing said conducting region and said self-aligned stack.

12. A method as claimed in any one of the foregoing Claims, characterized in that said first conductivity type is a P type, and said second conductivity type is an N type.

13. A method as claimed in any one of the foregoing Claims, characterized in that said conducting region is a drain region.

14. An EEPROM memory device comprising a memory cell (51; 61; 71) formed in a substrate (10) of semiconductor material presenting a first conductivity type and housing a conducting region (13) of a second conductivity type, said cell also comprising a tunnel insulating region (19) arranged on said substrate and surrounded by a gate insulating region (18), said tunnel insulating region being thinner than said gate insulating region, and said gate and tunnel insulating regions being offset laterally in relation to said conducting region; and a continuity region (54) of said second conductivity type, said continuity region being housed in said substrate beneath said tunnel insulating region (19) and in electric continuity with said conducting region (13); characterized in that said continuity region (54) is self-aligned with said tunnel insulating region (19).

15. A device as claimed in Claim 14, characterized in that it comprises an auxiliary region (63; 73) having said second conductivity type and being housed in said substrate (10) between and overlapping said continuity region (54) and said conducting region (13).
